# FASCICULE DE BREVET EUROPEEN

(11) **EP 0 577 447 B1**
(45) Date de publication et mention de la délivrance du brevet: **18.09.1996**
(21) Numéro de dépôt: 93401396.2
(22) Date de dépôt: 02.06.1993
(51) Int. Cl.: C23C 16/24, C23C 16/02, C23C 28/04

(54) **Procédé pour former un dépôt contenant du silicium à la surface d'un substrat métallique, procédé de traitement anti-corrosion**
Verfahren zur Herstellung einer Silizium-enthaltenden Schicht auf ein metallisches Substrat sowie Anti-Korrosionsbehandlung
Process for forming a silicon containing coating on a metallic substrate, anti-corrosion treatment process

(30) Priorité: 17.06.1992 FR 9207377
(43) Date de publication de la demande: 05.01.1994
(73) Titulaire: L'AIR LIQUIDE, SOCIETE ANONYME POUR L'ETUDE ET L'EXPLOITATION DES PROCEDES GEORGES CLAUDE, F-75321 Paris Cédex 07 (FR)
(72) Inventeur: Slootman, Frank, F-78210 St Cyr l'Ecole (FR); Bouard, Pascal, F-91210 Draveil (FR)
(74) Mandataire: Caen, Thierry Alain

(56) Documents cités:
- EP-A- 0 097 334
- EP-A- 0 199 307
- EP-A- 0 289 601
- EP-A- 0 353 060
- EP-A- 0 446 988
- GB-A- 2 107 360
- DATABASE WPI Derwent Publications Ltd., London, GB; AN 77-44612Y
- DATABASE WPI Derwent Publications Ltd., London, GB; AN 87-232388

## Description

La présente invention concerne un procédé pour former un dépôt contenant du silicium à la surface d'un substrat métallique, un procédé de traitement anti-corrosion d'un tel substrat métallique.

Il est connu que les substrats métalliques notamment des feuilles ou feuillards métalliques d'épaisseur faibles, sont souvent sensibles à la corrosion, induite notamment par l'eau ou la vapeur d'eau.

De nombreux procédés ont déjà été mis au point pour diminuer ces riques de corrosion. Il a ainsi déjà été proposé de déposer de la silice à la surface de ces substrats, la silice possédant des propriétés barrière vis-à-vis de la vapeur d'eau. De plus un dépôt de silice permet d'améliorer les propriétés d'adhésion et la mouillabilité de ces substrats. Les procédés mis en oeuvre pour ce faire font intervenir des techniques plasmas ou pyrolytiques. Cependant, les techniques plasmas utilisées jusqu'à présent nécessitent l'emploi de basses ou de très basses pressions, entraînant des coûts prohibitifs. De plus, le dépôt de silice ne peut être effectué que sur de petites surfaces, de l'ordre de 100 cm² (10 x 10 cm²). Cette technique n'est donc pas adaptée à des substrats de très grandes surfaces, tels des feuilles. Un problème similaire se pose également pour le traitement de film polymères métallisés présentant de grandes surfaces. Ces films sont notamment destinés à la fabrication de condensateurs électriques et utilisés dans le domaine de l'emballage. Ils sont constitués d'un film polymère tels une polyoléfine ou un polyester dont la surface est métallisé par un film ou un dépôt métallique composé d'un métal pur ou d'un alliage, et dont l'épaisseur est très faible, généralement inférieure à 25 nanomètres.

De part leurs faibles épaisseurs, ces films sont très sensibles à la corrosion, la partie métallique pouvant être substantiellement éliminée au bout de quelques heures de contact avec de la vapeur d'eau.

Les techniques pyrolytiques mentionnées ci-dessus, nécessitent la mise en oeuvre de températures élevées. Si de telles températures peuvent dans certains cas être supportées par des feuilles métalliques, elles sont cependant très supérieures aux températures de fusion des polymères constitutifs desdits films métallisés.

Les techniques pyrolytiques sont donc totalement inutilisables en vue du traitement de ces films.

La présente invention a alors pour principal objet un procédé permettant de former un dépôt contenant du silicium à la surface d'un substrat métallique, en vue d'améliorer notamment sa résistance à la corrosion, ses propriétés d'adhésion et sa mouillabilité. Ce procédé permet l'obtention d'un dépôt sur des substrats présentant de grandes surfaces. Il ne requiert pas la mise en oeuvre de basse pression ou de températures élevées, incompatibles avec des substrats du type films polymères métallisés.

L'invention concerne ainsi un procédé pour former un dépôt contenant du silicium à la surface d'un substrat métallique caractérisé en ce qu'il comprend, concomitamment ou successivement, les étapes suivantes:
(1) la soumission de ladite surface à une décharge électrique à barrière diélectrique,
(2) l'exposition de ladite surface à une atmosphère comportant un composé du silicium à l'état gazeux,
les étapes (1) et 2) étant effectuées à une pression supérieure à 10.000 Pa.

Avantageusement au moins l'étape (1) est effectuée à une pression comprise entre 50.000 et 120.000 Pa, et de préférence à la pression atmosphérique.

Le traitement par décharge électrique à barrière diélectrique effectué lors de l'étape, est bien connu en soi. Il consiste à produire une décharge électrique entre au moins une électrode et une contre-électrode. L'électrode, et le cas échéant la contre électrode, est recouverte d'un matériau diélectrique, tels le verre, un élastomère, un matériau céramique, l'alumine ou la silice. Un tel traitement peut notamment consister en une décharge luminescente ou "silent glow discharge", ou de manière préférée dans le cadre de la présente invention, en une décharge couronne.

Le traitement par la décharge couronne est également un traitement classique bien connu en lui-même, cf. par exemple, l'article "The flexible adaptation of the effective contact surface" de E. Prinz paru dans "Plastics Southern Africa", juin 183, pages 50 et suivantes, et l'article "Traitement par effet corona, considérations techniques sur l'équipement" de G. Tuffin paru dans "Plastiques Modernes et Elastomères", mai 1977, pages 54-56, qui donnent des indications sur le matériel à utiliser et les conditions opératoires.

Les étapes (1) et (2) décrites ci-dessus peuvent être effectuées concomitamment en ménageant une atmopshère comportant le composé du silicium à l'état gazeux dans la zone où l'on soumet ladite surface à une décharge électrique à barrière diélectrique.

Les étapes (1) et (2) peuvent également être effectuées successivement dans le temps, l'étape (1) étant effectuée dans un gaz contenant de l'oxygène, tel l'air, un gaz inerte, tels l'azote, l'argon ou l'hélium, ou un mélange de ces gaz. L'étape (2) peut alors être effectuée en exposant la surface du substrat à une atmosphère comportant le composé du silicium à l'état gazeux, ladite atmosphère régnant dans une zone faisant suite à la zone ou l'étape (1) est effectuée.

L'atmosphère comportant le composé du silicium à l'état gazeux mise en oeuvre lorsque les étapes (1) et (2) sont effectuées concomitamment ou dans l'étape (2) lorsque les étapes (1) et (2) sont effectuées successivement, comporte en outre généralement au moins un gaz inerte tels l'azote, l'argon ou l'hélium. On peut par exemple utiliser un composé du silicium à l'état gazeux dilué dans un mélange d'azote et d'argon.

Habituellement, la teneur du composé du silicium à l'état gazeux dans ladite atmosphère est comprise entre 0,01 et 5% en volume, de préférence entre 0,1 et 2 % en volume. La présence de faible teneur en oxygène dans l'atmosphère comportant le composé du silicium à l'état gazeux peut être tolérée dans certaines conditions. La teneur en oxygène devra bien entendu être inférieure à la limite d'inflammabilité du mélange gazeux comportant le composé du silicium.

Généralement cette teneur est inférieure à 5% en volume de préférence inférieure à 2% en volume par rapport au volume total du mélange gazeux. En vue du traitement de certains substrats, tels des films polymères métallisés, la teneur en oxygène sera la plus faible possible et de préférence elle sera nulle ou quasi nulle.

La température mise en oeuvre au cours des étapes (1) et (2) doit être inférieure à la température de fusion du substrat. Habituellement, la température mise en oeuvre est la température ambiante, soit une température d'environ 0 à 35°C.

La durée de contact entre la surface du substrat traité par la décharge électrique à barrière diélectrique et l'atmosphère comportant le composé du silicium à l'état gazeux n'est pas critique. Elle peut notamment être choisie en fonction de l'épaisseur désirée du dépôt contenant du silicium. Habituellement, le temps de contact est compris entre 10⁻³ seconde et 1 minute.

Le composé du silicium à l'état gazeux peut être un composé gazeux à la pression atmosphérique et à la température ambiante. Mais il peut également s'agir d'un composé solide ou liquide dans ces mêmes conditions de pression et de température, que l'on vaporise.

A titre de composé du silicium pouvant être mis en oeuvre dans le cadre de la présente invention, on peut citer les hydrures de silicium linéaires ou ramifiés de formule SiₙH₂ₙ₊₂, où n représente un nombre compris entre 1 et 4, tels le monosilane (SiH₄), le disilane ou le trisilane, les hydrures de silicium halogénés tels SiCl₄, SiH₂Cl₂, SiH₃Cl ou SiHCl₃, les alkoxysilanes tel le tétraéthoxysilane, ou les organosiloxanes. Le monosilane (SiH₄) est un composé du silicium préféré dans le cadre du procédé de l'invention.

La nature dudit dépôt contenant du silicium obtenu par le procédé selon l'invention peut varier notamment selon la nature du substrat, de la nature du composé du silicium à l'état gazeux et de la présence ou non d'oxygène au cours du procédé. Ce dépôt peut être constitué de dioxyde de silicium SiO₂ ou d'un oxyde de silicium sous-stoechiométrique en oxygène. Le silicium peut également se déposer à la surface du substrat métallique et y migrer de sorte à former un alliage de silicium et du métal ou des métaux constitutifs dudit substrat. Le dépôt contenant du silicium peut se présenter notamment sous la forme d'un film.

Le substrat métallique traité selon le procédé de l'invention peut être en tout métal susceptible d'être corrodé, en particulier par l'eau, la vapeur d'eau ou par l'oxygène. Notamment il peut être en fer, en nickel, en zinc, en aluminium, en cuivre, en argent ou en un alliage comportant au moins un de ces métaux tels un alliage d'argent et de zinc ou un acier.

Le substrat peut se présenter sous la forme d'une feuille ou d'un feuillard, dont l'épaisseur peut être inférieure à environ 5 mm.

Le substrat peut aussi être constitué d'un support polymère métallisé par un film ou un dépôt métallique, les étapes (1) et (2) étant effectuées à la surface libre du film ou du dépôt métallique ; ces derniers présentant généralement une épaisseur inférieure à 25 nanomètres. Ledit support peut notamment se présenter sous la forme d'un film polymère métallisé, le film polymère pouvant avoir une épaisseur inférieure à environ 250 µm, plus généralement comprise entre 10 et 40 µm. A titre de polymères pouvant constituer un tel support, on peut citer les polyoléfines tels le polyéthylène ou le polypropylène; les polyesters, les polyamides, les polycarbonates ou le polychlorure de vinyle. De tels substrats polymères métallisés peuvent être obtenus par des méthodes classiques, tel le dépôt sous vide.

Selon un autre aspect de l'invention, celle-ci concerne également un procédé de traitement anti-corrosion d'un substrat métallique, tels une feuille métallique ou un support polymère métallisé par un film ou un dépôt métallique caractérisé en ce qu'on dépose un film contenant du silicium à la surface métallique dudit substrat en mettant en oeuvre, concomitamment ou successivement, les étapes suivantes :
1) la soumission de ladite surface à une décharge électrique à barrière diélectrique,
2) l'exposition de ladite surface à une atmosphère comportant un composé du silicium à l'état gazeux,
les étapes (1) et (2) étant effectuées à une pression supérieure à 10.000 Pa.

L'exemple non limitatif ci-dessous a pour objet d'illustrer la présente invention.

### Exemple

On a traité un ruban de PET (polyéthylène téréphtalate) de 12 µm d'épaisseur et de 10 cm de largeur, métallisé par un alliage d'argent et de zinc selon une technique de dépôt sous vide, au moyen d'un dispositif de traitement par décharge couronne, en le faisant passer en continu entre l'électrode et la contre-électrode dudit dispositif. On a appliqué une tension d'environ 6000 volts entre les électrodes, la fréquence s'adaptant en conséquence entre environ 20 et 25 KHz. L'électrode, disposée au-dessus du ruban était constitué d'un tube en alumine entourant une âme métallique.

La contre-électrode était plane et servait de support au défilement du ruban. L'interstice entre les électrodes était d'environ 2 mm.

L'électrode et la contre-électrode étaient disposées dans une enceinte dans laquelle on introduisait un mélange gazeux constitué de 99% en volume d'argon et de 1 % en volume de silane, à un débit de 3 l/min.

La vitesse de déroulement dudit ruban entre l'électrode et la contre-électrode était de 5 m/min.

Afin d'apprécier la résistance à la corrosion du ruban de PET métallisé ainsi traité, on l'a exposé à une atmosphère saturée en vapeur d'eau, pendant 3 jours à la température ambiante.

Le degré de corrosion a alors été mesuré en projettant un faisceau lumineux au travers du ruban. La transmission lumineuse mesurée était de 2%.

A titre comparatif pour un même ruban de PET métallisé, non traité selon le procédé de l'invention et soumis au même test de corrosion, la transmission lumineuse était de 98%, ce qui indique une perte considérable du film métallique présent à la surface du ruban PET.

## Revendications

1. Procédé pour former un dépôt contenant du silicium à la surface d'un substrat métallique caractérisé en ce qu'il comprend, concomitamment ou successivement, les étapes suivantes :
1) la soumission de ladite surface à une décharge électrique à barrière diélectrique,
2) l'exposition de ladite surface à une atmosphère comportant un composé du silicium à l'état gazeux,
les étapes (1) et (2) étant effectuées à une pression supérieure à 10.000 Pa.

2. Procédé selon la revendication 1 caractérisé en ce qu'au moins l'étape 1) est effectuée à une pression comprise entre 50.000 et 120.000 Pa, de préférence à la pression atmosphérique.

3. Procédé selon l'une des revendications 1 et 2 caractérisé en ce que les étapes 1) et 2) sont effectuées à une température comprise entre 0 et 35°C.

4. Procédé selon l'une des revendications 1 à 3 caractérisé en ce que la décharge électrique à barrière diélectrique est une décharge couronne.

5. Procédé selon l'une des revendications 1 à 4 caractérisé en ce qu'on effectue concomitamment les étapes (1) et (2) en ménageant une atmosphère comportant un composé du silicium à l'état gazeux dans la zone où l'on soumet ladite surface à une décharge électrique à barrière diélectrique.

6. Procédé selon l'une des revendications 1 à 4 caractérisé en ce qu'on effectue successivement l'étape (1) puis l'étape (2), l'étape (1) étant effectuée dans un gaz contenant de l'oxygène, tel l'air, un gaz inerte, tels l'azote, l'argon ou l'hélium, ou un mélange de ces gaz, et l'étape (2) étant effectuée en exposant la surface du substrat à une atmosphère comportant un composé de silicium à l'état gazeux ladite atmosphère régnant dans une zone faisant suite à la zone ou l'étape (1) est effectuée.

7. Procédé selon l'une des revendications 1 à 6 caractérisé en ce que l'atmopshère comportant un composé du silicium à l'état gazeux comporte également au moins un gaz inerte tels l'azote, l'argon ou l'hélium.

8. Procédé selon l'une des revendications 1 à 7 caractérisé en ce que la teneur du composé du silicium à l'état gazeux dans ladite atmosphère est comprise entre 0,01 et 5 % en volume, de préférence entre 0,1 et 2% en volume.

9. Procédé selon l'une des revendications 1 à 8 caractérisé en ce que ledit composé du silicium est un hydrure de silicium linéaire, ou ramifié de formule SiₙH₂ₙ₊₂ où n représente un nombre compris entre 1 et 4, un hydrure de silicium halogéné, un alkoxysilane tel le tétraéthoxysilane ou un organosiloxane.

10. Procédé selon la revendication 9 caractérisé en ce que l'hydrure de silicium est le monosilane (SiH₄).

11. Procédé selon l'une des revendications 1 à 10 caractérisé en ce que ledit substrat est en fer, en nickel, en zinc, en aluminium, en cuivre, en argent ou en un alliage comportant au moins un de ces métaux, tel un alliage d'argent et de zinc ou un acier.

12. Procédé selon l'une des revendications 1 à 11 caractérisé en ce que le substrat est sous forme d'une feuille ou d'un feuillard.

13. Procédé selon l'une des revendications 1 à 11 caractérisé en ce que le substrat est un support polymère métallisé par un film ou un dépôt métallique, les étapes (1) et (2) étant effectuées à la surface libre dudit film ou dépôt métallique.

14. Procédé selon la revendication 13 caractérisé en ce le support polymère est en une polyoléfine tels le polyéthylène ou le polypropylène, un polyester, un polyamide, un polycarbonate ou le polychlorure de vinyle.

15. Procédé selon l'une des revendications 1 à 14 caractérisé en ce que ledit dépôt est constitué de dioxyde de silicium ou d'un oxyde de silicium sous-stoéchiométrqiue en oxygène.

16. Procédé selon l'une des revendications 1 à 15 caractérisé en ce que ledit dépôt se présente sous la forme d'un film.

17. Procédé de traitement anti-corrosion d'un substrat métallique, tels une feuille métallique ou un support polymère métallisé par un film ou un dépôt métallique caractérisé en ce qu'on forme un dépôt contenant du silicium à la surface métallique dudit substrat en mettant en oeuvre, concomitamment ou successivement, les étapes suivantes :
(1) on soumet ladite surface à une décharge électrique à barrière diélectrique, telle une décharge couronne,
et (2) on expose ladite surface à une atmosphère comportant un composé du silicium à l'état gazeux.
Les étapes (1) et (2) étant effectuées à une pression supérieure à 10.000 Pa, de préférence à la pression atmosphérique.

## Patentansprüche

1. Verfahren zur Herstellung einer Silizium enthaltenden Schicht auf der Oberfläche eines metallischen Substrats, gekennzeichnet durch die folgenden gleichzeitig oder nacheinander ausgeführten Schritte, in denen:
1) die Oberfläche über eine dielektrische Elektrode einer elektrischen Entladung unterzogen wird,
2) die Oberfläche einer Atmosphäre ausgesetzt wird, die eine gasförmige Siliziumverbindung enthält,
wobei die Schritte (1) und (2) bei einem Druck über 10.000 Pa durchgeführt werden.

2. Verfahren nach Anspruch 1, dadurch gekennzeichnet, daß wenigstens der Schritt (1) bei einem Druck zwischen 50.000 und 120.000 Pa, vorzugsweise bei atmosphärischem Druck, durchgeführt wird.

3. Verfahren nach einem der Ansprüche 1 oder 2, dadurch gekennzeichnet, daß die Schritte 1) und 2) bei einer Temperatur zwischen 0 und 35°C durchgeführt werden.

4. Verfahren nach einem der Ansprüche 1 bis 3, dadurch gekennzeichnet, daß die elektrische Entladung über eine dielektrische Elektrode eine Koronaentladung ist.

5. Verfahren nach einem der Ansprüche 1 bis 4, dadurch gekennzeichnet, daß die Schritte (1) und (2) gleichzeitig durchgeführt werden, wobei dort, wo die Oberfläche über eine dielektrische Elektrode einer elektrischen Entladung ausgesetzt wird, eine Atmosphäre vorgesehen ist, die eine gasförmige Siliziumverbindung enthält.

6. Verfahren nach einem der Ansprüche 1 bis 4, dadurch gekennzeichnet, daß nacheinander Schritt (1) und dann Schritt (2) durchgeführt wird, wobei Schritt (1) in einem sauerstoffhaltigen Gas, wie Luft, einem Inertgas, wie Stickstoff, Argon oder Helium, oder einem Gemisch dieser Gase durchgeführt wird, und in Schritt(2) die Oberfläche des Substrats einer Atmosphäre ausgesetzt wird, die eine gasförmige Siliziumverbindung enthält, wobei diese Atmosphäre in einem Bereich herrscht, der auf den Bereich, in dem Schritt (1) durchgeführt wird, folgt.

7. Verfahren nach einem der Ansprüche 1 bis 6, dadurch gekennzeichnet, daß die Atmosphäre mit einer gasförmigen Siliziumverbindung auch wenigstens ein Inertgas wie Stickstoff, Argon oder Helium umfaßt.

8. Verfahren nach einem der Ansprüche 1 bis 7, dadurch gekennzeichnet, daß der Gehalt der gasförmigen Siliziumverbindung in der Atmosphäre zwischen 0,01 und 5 Vol.-% , vorzugsweise zwischen 0,1 und 2 Vol.-% beträgt.

9. Verfahren nach einem der Ansprüche 1 bis 8, dadurch gekennzeichnet, daß die Siliziumverbindung ein geradkettiges Silan oder ein verzweigtes Silan mit der Formel SiₙH₂ₙ₊₂, wobei n eine Zahl zwischen 1 und 4 ist, ein halogenhaltiges Silan, ein Alkoxysilan, wie Tetraethoxysilan oder ein Organosiloxan ist.

10. Verfahren nach Anspruch 9, dadurch gekennzeichnet, daß das Silan ein Monosilan (SiH₄) ist.

11. Verfahren nach einem der Ansprüche 1 bis 10, dadurch gekennzeichnet, daß das Substrat aus Eisen, Nickel, Zink, Aluminium, Kupfer, Silber oder aus eine Legierung aus wenigstens einem dieser Materialien, wie eine Silber-Zink-Legierung oder Stahl ist.

12. Verfahren nach einem der Ansprüche 1 bis 11, dadurch gekennzeichnet, daß das Substrat blatt- oder bandförmig ist.

13. Verfahren nach einem der Ansprüche 1 bis 11, dadurch gekennzeichnet, daß das Substrat ein metallisierter Polymerträger mit einem Film oder einer metallischen Schicht ist, wobei die Schritte (1) und (2) auf der freien Oberfläche des Films oder der metallischen Schicht durchgeführt werden.

14. Verfahren nach Anspruch 13, dadurch gekennzeichnet, daß der Polymerträger ein Polyolefin, wie Polyethylen, Polypropylen, Polyester, Polyamid, Polykarbonat oder Polyvinylchlorid ist.

15. Verfahren nach einem der Ansprüche 1 bis 14, dadurch gekennzeichnet, daß die Schicht aus Siliziumdioxid oder einem, bezüglich Sauerstoff nicht-stöchiometrischen Siliziumoxid besteht.

16. Verfahren nach einem der Ansprüche 1 bis 15, dadurch gekennzeichnet, daß die Schicht die Form eines Filmes hat.

17. Verfahren zur Antikorrosionsbehandlung eines metallischen Substrats, wie einem metallischen Blatt oder einem Polymerträger, der mit einem Film oder einer metallischen Schicht metallisiert ist, dadurch gekennzeichnet, daß eine Silizium enthaltende Schicht auf der metallischen Oberfläche des Substrats gebildet wird, wobei das Substrat gleichzeitig oder aufeinanderfolgend gemäß folgenden Schritten behandelt wird, in denen:
1) die Oberfläche über eine dielektrische Elektrode einer elektrischen Entladung, wie einer Koronaentladung unterzogen wird,
und 2) die Oberfläche einer Atmosphäre ausgesetzt wird, die eine gasförmige Siliziumverbindung enthält.
Die Schritte (1) und (2) werden bei einem Druck über 10.000 Pa, vorzugsweise bei atmosphärischem Druck durchgeführt.

## Claims

1. Process for forming a deposit containing silicon on the surface of a metal substrate characterized in that it comprises, concomitantly or successively, the following stages:
1) subjecting the said surface to a dielectric barrier electrical discharge,
2) exposing the said surface to an atmosphere containing a silicon compound in the gaseous state,
stages (1) and (2) being carried out at a pressure greater than 10,000 Pa.

2. Process according to claim 1 characterized in that at least stage (1) is carried out at a pressure of between 50,000 Pa and 120,000 Pa, preferably at atmospheric pressure.

3. Process according to either claim 1 or claim 2 characterized in that stages (1) and (2) are carried out at a temperature of between 0°C and 35°C.

4. Process according to one of claims 1 to 3 characterized in that the dielectric barrier electrical discharge is a corona discharge.

5. Process according to one of claims 1 to 4 characterized in that stages (1) and (2) are carried out concomitantly by using an atmosphere containing a silicon compound in the gaseous state in the zone where the said surface is subjected to a dielectric barrier electrical discharge.

6. Process according to one of claims 1 to 4 characterized in that stages (1) and then (2) are carried out successively, stage (1) being carried out in a gas containing oxygen, such as air, an inert gas, such as nitrogen, argon or helium, or a mixture of these gases, and stage (2) being carried out by exposing the surface of the substrate to an atmosphere containing a silicon compound in the gaseous state, the said atmosphere existing in a zone following the zone in which stage (1) is carried out.

7. Process according to one of claims 1 to 6 characterized in that the atmosphere containing a silicon compound in the gaseous state also contains at least one inert gas such as nitrogen, argon or helium.

8. Process according to one of claims 1 to 7 characterized in that the concentration of the silicon compound in the gaseous state in the said atmosphere is between 0.01 % and 5 % by volume, preferably between 0.1 % and 2 % by volume.

9. Process according to one of claims 1 to 8 characterized in that the said silicon compound is a linear or branched silicon hydride with the formula SiₙH₂ₙ₊₂ where n represents a number between 1 and 4, a halogenated silicon hydride, an alkoxysilane such as tetraethoxysilane or an organosilane.

10. Process according to claim 9 characterized in that the silicon hydride is monosilane SiH₄.

11. Process according to one of claims 1 to 10 characterized in that the said substrate is made of iron, nickel, zinc, aluminium, copper, silver or an alloy containing at least one of these metals, such as an alloy of silver and of zinc or a steel.

12. Process according to one of claims 1 to 11 characterized in that the substrate is in the form of a foil or strip.

13. Process according to one of claims 1 to 11 characterized in that the said substrate is a polymeric support metallized with a metal film or deposit, stages (1) and (2) being carried out at the free surface of the said metal film or deposit.

14. Process according to claim 13, characterized in that the polymeric support is a polyolefin such as polyethylene or polypropylene, a polyester, a polyamide, a polycarbonate or polyvinyl chloride.

15. Process according to one of claims 1 to 14, characterized in that the said deposit consists of silicon dioxide or a silicon oxide sub-stoichiometric in oxygen.

16. Process according to one of claims 1 to 15, characterized in that the said deposit is in the form of a film.

17. Process for the anti-corrosive treatment of a metal substrate, such as a metal foil or a polymeric support metallized with a film or a metal deposit characterized in that a deposit is formed containing silicon on the metal surface of the said substrate by putting the following stages into operation, concomitantly or successively :
1) the said surface is subjected to a dielectric barrier electrical discharge,
2) the said surface is exposed to an atmosphere containing a silicon compound in the gaseous state,
stages (1) and (2) being carried out at a pressure greater than 10,000 Pa, preferably at atmospheric pressure.
